# DEMANDE DE BREVET EUROPEEN

(11) **EP 1 764 684 A1**
(43) Date de publication de la demande: **21.03.2007**
(21) Numéro de dépôt: 05300708.4
(22) Date de dépôt: 01.09.2005
(51) Int. Cl.: G06F 9/44, G06F 17/50

(54) **Structure de données et procedé de création d'une documentation de logiciel**

(71) Demandeur: ALCATEL, 75008 Paris (FR)
(72) Inventeur: Larvet, Philippe, 91470 Forges les Bains (FR); Pastor, Alain, 78141 Velizy (FR)
(74) Mandataire: Sciaux, Edmond

(57) **Abrégé**

L'invention concerne une structure de données accessible par un assistant (50) de génération de documentation de logiciel. Cette structure comprend des identificateurs de section d'un document et des identificateurs d'élément de modélisation d'un modèle de développement (36) compatible avec un formalisme de modélisation d'objets, par exemple UML. La structure de données comprend en outre des identificateurs d'opération de traitement et des mises en correspondance des divers identificateurs.

L'invention concerne également un procédé de génération d'une documentation, qui recherche (E20) la structure correspondant à la documentation souhaitée (E10). Des opérations de récupération de données, identifiées dans ladite structure sont réalisées (E40) pour chacune des sections. Les éléments de modélisation fournissent des arguments pour ces opérations. Ainsi, il est possible de construire automatiquement une documentation par agrégation des différents éléments trouvés (E30) dans le modèle de développement et correspondant à la structure de données.

## Description

La présente invention concerne une structure de données accessible par un programme d'aide à l'utilisateur et un procédé de création d'une documentation de logiciel.

Dans la présente description, les termes suivants sont employés avec le sens indiqué :
- « classe » : désigne la notion de classe communément manipulée dans les formalismes de modélisation et langages de programmation orientés objet et notamment l'agrégation de données et de traitements (ou attributs et méthodes, respectivement) destinés à fonctionner ensemble dans une application informatique. Dans les langages orientés objet, chaque type d'objet est définie par sa classe. Une classe représente l'ensemble des objets partageant les mêmes attributs, opérations, méthodes, relations et sémantiques.
- « conteneur » : en programmation orientée objet, un objet comprenant d'autres objets, tel qu'un dictionnaire, et qui fournit les opérations pour accéder à son contenu. Il peut aussi s'agir d'un composant comprenant d'autres composants.
- « diagramme » : une représentation graphique d'une collection d'éléments de modélisation, montrant par exemple un graphe d'arcs (relations) et des sommets (autres éléments de modélisation). La norme UML propose les diagrammes suivants : diagramme de classes, diagramme d'objets, diagramme de cas d'utilisation, diagramme de séquence, diagramme de collaboration, diagramme d'états transitions, diagramme d'activités, diagramme de composants et diagramme de déploiement.
- « modélisation » désigne la représentation abstraite d'un énoncé, d'un problème ou d'un système, réalisée d'une part dans un but de compréhension et de communication de cette compréhension, et d'autre part dans un but de résolution du problème ou d'implémentation concrète du système.
- « Model Driven Architecture » (MDA) désigne un ensemble de spécifications de l'OMG, lesquelles ont trait à un processus de développement utilisant une suite de modèles. Ces modèles intègrent plusieurs dimensions du projet et s'étendent du modèle fonctionnel au modèle code source. Ces modèles obéissent au standard UML. La progression d'un modèle à l'autre comprend un enrichissement progressif des spécifications de l'application et utilise des transformations autorisées par le méta modèle UML.
- « modélisation orientée objet » désigne un type particulier de modélisation dans laquelle les éléments de modélisation sont des classes, objets, attributs, méthodes, associations, etc. par opposition à "modélisation fonctionnelle" dans laquelle les éléments de modélisation sont des fonctions de traitement et des flux de données. Voir aussi « UML ».
- « MOF » (pour Meta Object Facility) est un langage de métamodélisation proposé par l'OMG et utilisé pour spécifier la syntaxe d'UML et d'autres langages de modélisation.
- « OMG » (pour « Object Management Group »), désigne une organisation dont l'un des buts est de définir des standards afin de garantir la compatibilité entre des applications programmées à l'aide de langages orientés objet (cf. http://www.omg.org).
- « objet » : désigne, en modélisation ou en programmation orientée objet, une instance de classe, constitué d'un ensemble de données (les propres données définitoires de la classe) et des procédures utiles à leur manipulation.
- « orienté objet », se dit par exemple d'un modèle, d'un langage, d'une application ou d'éléments d'applications dont les constituants sont des classes et des objets. Par exemple un langage orienté objet est un langage de programmation dans lequel les composants de base sont des classes, dont les instances - les objets - vivent dynamiquement dans le programme informatique qui les utilise.
- « stéréotype » (stereotype), désigne un type d'élément de modélisation qui étend la sémantique du métamodèle. Les stéréotypes doivent être basés sur certains types ou classes existants dans le métamodèle. Les stéréotypes peuvent étendre la sémantique, mais pas la structure des types et des classes préexistants. Certains stéréotypes sont prédéfinis dans le langage UML, d'autres peuvent être définis par l'utilisateur. Les stéréotypes constituent, avec les "tagged values" et les "annotations", un des trois mécanismes d'extension du langage UML.
- « UML » (Unified Modeling Language, que l'on peut traduire par «langage de modélisation unifié) : désigne une notation (plutôt qu'un langage) de modélisation par objets, permettant de déterminer et de présenter les composants d'un système objet lors de son développement, ainsi que, le cas échéant, d'en générer la documentation. UML est actuellement la norme OMG. Il résulte de la fusion des travaux de Jim Rumbaugh, Grady Booch et Ivar Jacobson et connaît de nombreuses évolutions. La notation UML, telle qu'elle est actuellement normalisée, propose une représentation graphique pour différents diagrammes (voir ci-dessus).

On connaît la modélisation dite « modélisation objet », qui consiste à créer une représentation d'éléments du monde réel en termes de classes et d'objets, indépendamment de tout langage de programmation. Par exemple, des classes d'objets sont déterminées, leurs données propres et les fonctions qui les utilisent sont isolées. Divers formalismes existent. UML est l'un de ces formalismes (il s'agît en fait plutôt d'un catalogue de notations).

Les langages orientés objet constituent chacun une manière spécifique d'implémenter le concept de classe. En particulier, un formalisme ou une méthode objet permet de définir un problème à « haut niveau d'abstraction» sans rentrer dans les spécificités d'un langage donné. Il offre également, via UML, un outil permettant aisément de représenter un problème de façon graphique, le rendant plus accessible aux différents acteurs intervenant dans sa résolution.

Typiquement, il est tout d'abord procédé à une conception abstraite d'un modèle objet, par exemple en vue de la résolution d'un problème donné. Ensuite, il est procédé à l'implémentation du modèle à l'aide d'un langage orienté objet (tel que le langage C# ou Java).

Il est donc souhaitable qu'un formalisme objet soit défini le plus rigoureusement possible, de préférence qu'il soit unique et ce, afin de restreindre au maximum les ambiguïtés. Parmi les différentes notations qui ont été développées, UML s'est imposé dans le courant des années 90, en tant que norme de l'OMG.

Dans le cadre d'un développement de projet logiciel, par exemple selon les spécifications MDA, un problème qui se pose est d'écrire la documentation de projet (spécifications du logiciel, architecture du logiciel, conception détaillée du logiciel, plan d'essai du logiciel, etc.) conformément à un cahier des charges.

Deux solutions dites « manuelles » s'offrent à ce problème.

La première consiste à éditer dans un programme de traitement de texte un document de projet et à en recopier certaines parties dans la documentation puis la compléter.

La deuxième solution consiste à faire appel aux outils de modélisation tels que Rational Rose® de IBM, Objecteering® de Softeam, Rhapsody® de i-Logix, utilisés pour le projet. Ces outils permettent de réaliser une modélisation abstraite d'une application informatique en utilisant UML. Incidemment, ils permettent en outre de générer du code, à partir d'une représentation interne propriétaire. En ce qui concerne la création de la documentation désirée, il est néanmoins nécessaire de modifier la structure des fichiers de documentation obtenus grâce à ces outils. En effet, malgré leurs possibilités de paramétrisation, ces outils ne permettent pas d'obtenir la structure exacte voulue pour les documentations.

Les solutions exposées ci-dessus ne sont, en soi, déjà pas satisfaisantes compte tenu de leur manque d'automatisation. Elles sont d'autant moins satisfaisantes qu'un développement de projet logiciel nécessite la plupart du temps de réaliser une documentation avant que ne soit achevée la version finale du logiciel. Or, compte tenu des diverses modifications ayant lieu au cours du développement, il est très souvent nécessaire de modifier la documentation, ce qui oblige à de nouvelles interventions manuelles dans la documentation précédemment réalisée.

Il existe donc un besoin pour un procédé de création d'une documentation de logiciel et une structure de données utilisable par ce procédé qui permettent d'automatiser la réalisation d'une documentation de logiciel.

A cette fin, l'invention propose une structure de données accessible par un programme d'aide à l'utilisateur, comprenant au moins un identificateur de section d'un document, au moins un identificateur d'élément de modélisation d'un modèle de développement compatible avec un formalisme de modélisation d'objets, au moins un identificateur d'opération de traitement, et au moins une mise en correspondance de l'identificateur de section, l'identificateur d'élément de modélisation et l'identificateur d'opération de traitement.

Dans des modes de réalisation préférés, la structure de données selon l'invention comprend une ou plusieurs des caractéristiques suivantes :
- l'identificateur d'élément de modélisation comprend un identificateur de diagramme objet du modèle de développement et un identificateur de stéréotype du modèle de développement et la mise en correspondance comprend une première mise en correspondance de l'identificateur de section avec l'identificateur de diagramme objet, une deuxième mise en correspondance de l'identificateur de diagramme objet avec l'identificateur de stéréotype et une troisième mise en correspondance de l'identificateur de stéréotype avec l'identificateur d'opération de traitement ;
- le formalisme de modélisation d'objets est la notation UML ; et
- l'opération de traitement est une opération de récupération de contenu, de liste ou de diagramme ;

L'invention concerne également un produit de programme d'ordinateur, adapté à valoriser, à accéder et/ou à manipuler la structure de données selon l'invention ;

L'invention concerne en outre un fichier lisible par ordinateur, comprenant une représentation de la structure de données selon l'invention.

L'invention propose encore un procédé de génération d'une documentation de logiciel, comprenant une étape d'accession à la structure de données selon l'invention et d'accession au modèle de développement.

Dans des modes de réalisation préférés, le procédé selon l'invention comprend une ou plusieurs des caractéristiques suivantes :
- le procédé comprend en outre, à l'étape d'accession une étape de lecture de l'identificateur de section, une étape de lecture de l'identificateur d'élément de modélisation, en fonction de ladite mise en correspondance et une étape de recherche dans le modèle de développement de l'élément de modélisation correspondant à l'identificateur d'élément de modélisation;
- Le procédé selon l'invention comprend en outre une étape de lecture de l'identificateur d'opération en fonction de ladite mise en correspondance ;
- Le procédé selon l'invention comprend en outre une étape d'exécution d'une opération correspondant à l'identificateur d'opération ; et
- Le procédé selon l'invention comprend en outre une étape d'ouverture d'un fichier de documentation et une étape d'écriture, dans ce fichier, de données retournées lors de ou en suite à l'exécution de ladite opération.

D'autres caractéristiques et avantages de l'invention apparaîtront à la lecture de la description détaillée qui suit des modes de réalisation de l'invention, donnés à titre d'exemple uniquement et en références à des exemples, ainsi qu'aux schémas annexés, qui montrent :
- Figure 1 : une représentation d'une structure de données selon un mode de réalisation de l'invention; et
- Figure 2 : un ordinogramme représentant schématiquement certaines étapes du procédé selon l'invention, dans un mode de réalisation.

L'idée sous-jacente à l'invention est de considérer une documentation comme un sous-produit du modèle de développement du logiciel. En situation, le modèle de développement est construit petit à petit puis complété par ajout de tous le détails utiles. L'idée exposée dans l'invention décrite ci-après est de générer la documentation à partir de ce modèle.

Plus spécifiquement, chaque document de projet (par exemple de spécifications du logiciel, d'architecture du logiciel, de conception détaillée du logiciel, etc.) va être décrit par une structure de donnée, que l'on peut concevoir également comme un « arbre abstrait » (ou « abstract tree » en anglais), dont certaines branches et feuilles renvoient à des parties spécifiques d'un modèle de développement générique.

Par « structure de données », on entend tout d'abord la structure effective des données telles qu'elles sont manipulées dans la représentation interne d'un programme qui les exploite. En particulier, la présente structure de données est accessible par un programme d'aide à l'utilisateur, c'est-à-dire un programme d'aide intégré à un logiciel, adapté à guider l'utilisateur dans l'exécution de certaines tâches, par exemple via l'affichage de boîtes de dialogue successives. On entend cependant également par « structure de données » la structure des informations présentes dans un fichier, telle qu'elle apparaîtrait lors de l'édition de ce fichier ou lors de son impression. Ce fichier pourrait par exemple être un fichier de réification de la « structure de données » ci-dessus, telle qu'entendue dans son premier sens.

Selon l'invention, cette structure de données comprend au moins un identificateur de section d'un document et au moins un identificateur d'élément de modélisation d'un modèle de développement compatible avec un formalisme de modélisation d'objets. De préférence et en pratique, l'identificateur d'élément de modélisation se décompose lui-même comme un identificateur de diagramme objet et un identificateur de stéréotype du modèle de développement. La structure de donnée comprend en outre au moins un identificateur d'opération de traitement. Elle comprend également au moins une mise en correspondance de l'identificateur de section, l'identificateur d'élément de modélisation et l'identificateur d'opération de traitement. Typiquement, la structure de données comprend plusieurs identificateurs et mises en correspondances.

Le formalisme de modélisation peut par exemple être la notation UML, auquel cas les éléments de modélisation sont les éléments classiquement manipulés par UML, c'est-à-dire des paquetages, classes, attributs, opérations, associations, cardinalités, héritages, etc.

Par mise en correspondance (« data mapping »), on entend une association des données appartenant à un ensemble avec les données appartenant à un autre ensemble, de sorte que les données du premier ensemble puissent éventuellement se substituer à celles du second ensemble, et surtout qu'il soit possible de passer des premières aux secondes lors d'une lecture systématique (par exemple une lecture informatique).

Plus en détails, le but poursuivi est la réalisation des opérations identifiées dans la structure de données et ce, pour chacune des sections d'un document. L'élément de modélisation fournit un ou des arguments pour ces opération, par exemple conformément au stéréotype indiqué dans la structure de données et présent dans le modèle de développement. L'association entre les divers éléments décrits ci-dessus se fait grâce aux mises en correspondance des identificateurs de section, d'élément de modélisation et d'opération de traitement. Ainsi, il est possible, via une procédure adaptée, d'accéder à (et donc lire) cette structure de données et de balayer le modèle de développement afin de construire la documentation. Ceci se fait par agrégation des différents éléments trouvé dans le modèle de développement et correspondant à la structure de donnée.

En pratique, chaque structure de donnée ou arbre est stockée dans un catalogue, auquel accède l'assistant de documentation. Cet outil permet à l'utilisateur de générer automatiquement à tout moment une documentation reflétant un état courant du développement du logiciel. Ceci évite notamment des incohérences entre la documentation et le logiciel, comme il arrive souvent. Une telle solution est en outre simple et facile d'utilisation. La documentation générée est de plus conforme à l'assurance qualité, étant donné que le paramétrage de la structure de données est réalisé conformément aux plans-types de documents de projet, tels qu'ils sont par exemple fournis par la cellule qualité du projet. Ceci implique cependant que le modèle de développement soit renseigné de manière adéquate et ce, au fur et à mesure du développement.

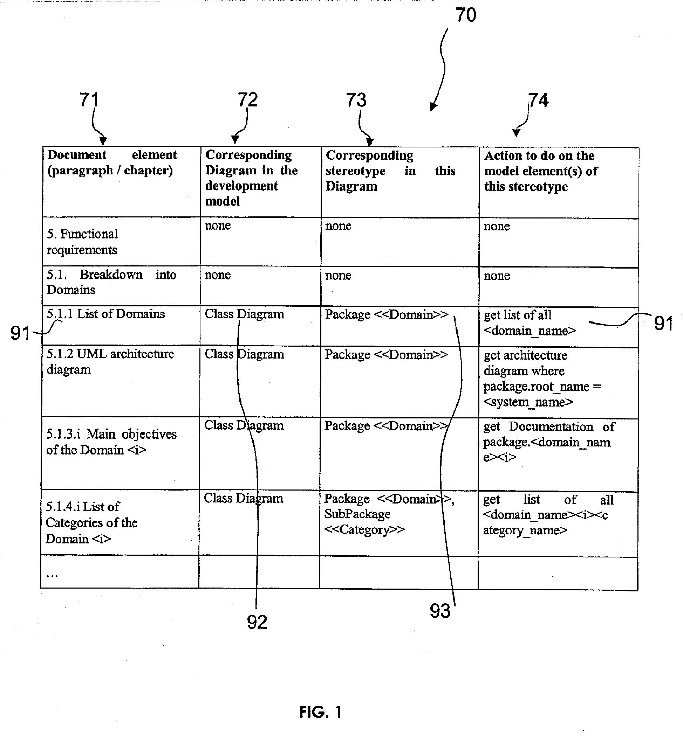

La figure 1 représente une structure de données selon un mode de réalisation de l'invention. En référence à cette figure, la structure de données 70, une fois réifiée, se présente sous la forme d'un tableau comprenant plusieurs colonnes 71 - 74. Les éléments figurant dans ces colonnes sont en langue anglaise, comme il est usuel dans l'art. La première colonne 71 se rapporte à des éléments de document, par exemple des sections telles que des chapitres ou paragraphes (voir par exemple la référence 91 : « 5.1.1 List of Domains »). La deuxième colonne 72 comprend des identificateurs de diagramme objet du modèle de développement (par exemple « class diagram », référence 92). Les stéréotypes (par exemple « Package <<Domain>> », référence 93) sont identifiés dans la troisième colonne 73 et les opérations de traitement correspondantes (par exemple « Package get list of all <domain_name>», référence 94) sont identifiées dans la quatrième colonne 74. Les mises en correspondances sont, dans cet exemple, implicites, c'est-à-dire qu'elles sont révélées par l'ordre de stockage des éléments ou le format du fichier correspondant à la structure de données. Le procédé d'accession/lecture du fichier doit alors être adapté en conséquence. Dans l'exemple de la figure, ce procédé doit pouvoir interpréter le fait que les i^{ièmes} éléments de chacune des colonnes sont mis en correspondance.

Une telle structure de données est particulièrement simple. Une fois la structure de données réifiée en un fichier, sa compréhension par un utilisateur s'en trouve simplifiée.

Il convient de noter que les opérations ou actions devant être réalisées ne sont pas des éléments de modélisation, du moins pas au sens classique. Spécifiques au contexte de l'invention, ces opérations sont associées, dans la structure de données, aux éléments de modélisation, mais elles ne figurent pas nécessairement dans le modèle.

Ces opérations sont typiquement des opérations de récupération de contenu, de liste ou de diagramme, par exemple identifiés comme « GET_CONTENT », « GET_LIST » ou « GET_DIAGRAM ». Les types d'opérations peuvent dépendre du contexte dans lequel est utilisé la structure de données ci-dessus, le but étant de pouvoir récupérer de l'information contenue dans les éléments de modélisation d'un modèle objet.

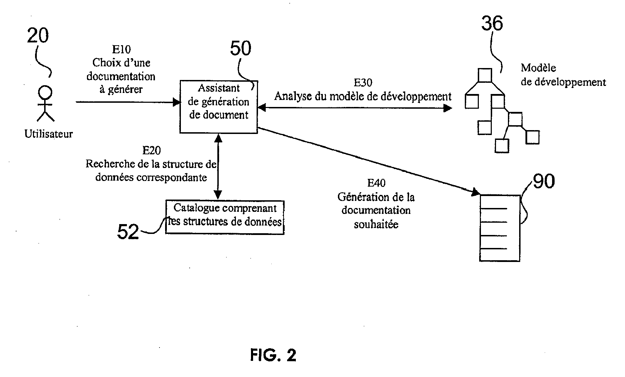

Comme mentionné ci-dessus, des tables telles que représentées à la figure 1 sont écrites pour chaque type de documentation devant être générée et sont stockées dans un catalogue. Ce catalogue est accessible par l'assistant de génération de documentation, lequel est adapté à mettre en oeuvre le procédé qui va maintenant être décrit en référence à la figure 2.

La figure 2 montre un ordinogramme représentant schématiquement certaines étapes du procédé selon l'invention.

En situation, un utilisateur 20 choisit grâce à l'assistant 50 une documentation à générer (étape E10). Le procédé comprend alors une étape d'accession E20 à la structure de données (cf. référence 70 dans la figure 1) correspondant à la documentation à générer, comprise dans le catalogue 52. Lors de cette étape peut avoir lieu une lecture :
- des identificateurs de section ;
- des identificateurs d'éléments de modélisation (soit par exemple des identificateurs 92 et 93, respectivement de diagramme objet et de stéréotype dans l'exemple de la figure 1) ; et
- des identificateurs d'opérations.

Ces étapes de lecture se font de préférence en fonction des mises en correspondance figurant dans la structure de données. Cependant, ces mises en correspondances ne pourraient être prises en compte par l'algorithme qu'au moment de l'exécution subséquente des opérations correspondantes.

Avant d'exécuter ces opérations, l'assistant 50 balaye le modèle de développement 36 : il y recherche (étape E30) les éléments de modélisation correspondant aux identificateurs lus dans la structure de données. Il recherche par exemple le diagramme objet pertinent dans le modèle 36, puis le stéréotype identifié, dans ce dernier diagramme.

Le modèle de développement est typiquement construit grâce à des outils tels que ceux évoqués plus haut, c'est-à-dire Rational Rose®, Objecteering® ou Rhapsody®.

Les éléments de modélisation fournissant les arguments nécessaires, l'assistant 50 peut alors exécuter (étape E40) les opérations correspondant aux identificateurs lus dans la structure, sur la base des mises en correspondances figurant dans celle-ci.

Afin de générer la documentation proprement dire, l'assistant ouvre un fichier 90 correspondant à la documentation devant être générer. L'assistant inscrit dans ce fichier 90 des données retournées lors de ou en suite à l'exécution des opérations décrites ci-dessus. Ces données sont typiquement des contenus, des listes ou des diagrammes et ont inscrits conformément aux sections de documents.

Dans un mode de réalisation, l'enchaînement des étapes effectuées par l'assistant correspond au script suivant :
- Recherche (E20) de la structure de données correspondant à la documentation 90 à dans le catalogue 52
- Pour chacune des lignes de la structure de données trouvée :
- écrire le titre de section (première colonne) dans le fichier de documentation ;
- Si (deuxième colonne) n'est pas aucun ("none"):
- Recherche le diagramme identifié(deuxième colonne) dans le modèle de développement 36 ;
- Rechercher le stéréotype (troisième colonne) dans le diagramme ;
- Exécuter l'opération (quatrième colonne) sur ce stéréotype et écrire les données correspondante dans le fichier 90 de documentation ;
- Fin du test ;
- Fin de la boucle.

Le procédé décrit ci-dessus assure une parfaite correspondance, quant au fond, entre la documentation générée et l'état courant du modèle de développement.

L'invention n'est cependant pas limitée aux variantes décrites ci avant mais est susceptible de nombreuses autres variations aisément accessibles à l'homme du métier. A titre d'exemple, il est possible d'introduire explicitement les mises en correspondance dans la structure de données et de modifier le procédé de lecture en conséquence.

## Revendications

1. Structure de données (70) accessible par un programme d'aide à l'utilisateur (50), comprenant :
- au moins un identificateur (91) de section d'un document ;
- au moins un identificateur (92, 93) d'élément de modélisation d'un modèle (36) de développement compatible avec un formalisme de modélisation d'objets ;
- au moins un identificateur (94) d'opération de traitement ; et
- au moins une mise en correspondance de l'identificateur (91) de section, l'identificateur (92, 93) d'élément de modélisation et l'identificateur (94) d'opération de traitement.

2. La structure de données (70) selon la revendication 1, dans laquelle l'identificateur (92, 93) d'élément de modélisation comprend :
- un identificateur (92) de diagramme objet du modèle (36) de développement ; et
- un identificateur (93) de stéréotype du modèle de développement ;
et dans laquelle la mise en correspondance comprend :
- une première mise en correspondance de l'identificateur (91) de section avec l'identificateur (92) de diagramme objet;
- une deuxième mise en correspondance de l'identificateur (92) de diagramme objet avec l'identificateur (93) de stéréotype ; et
- une troisième mise en correspondance de l'identificateur (93) de stéréotype avec l'identificateur (94) d'opération de traitement.

3. La structure de données (70) selon la revendication 1 ou 2, dans laquelle le formalisme de modélisation d'objets est la notation UML.

4. La structure de données (70) selon la revendication1, 2 ou 3, dans laquelle l'opération de traitement est une opération de récupération de contenu, de liste ou de diagramme.

5. Produit de programme d'ordinateur (50), adapté à valoriser, à accéder et/ou à manipuler la structure de données (70) selon l'une quelconque des revendications 1 à 4.

6. Fichier (70) lisible par ordinateur, comprenant une représentation de la structure de données (70) selon l'une quelconque des revendications 1 à 4.

7. Procédé de génération d'une documentation de logiciel, comprenant :
- une étape d'accession (E20) à la structure de données (70) selon l'une quelconque des revendications 1 à 4 et d'accession (E30) au modèle (36) de développement.

8. Le procédé selon la revendication 7, comprenant en outre, à l'étape d'accession (E20):
- une étape de lecture de l'identificateur (91) de section ;
- une étape de lecture de l'identificateur (92, 93) d'élément de modélisation, en fonction de ladite mise en correspondance ; et
- une étape de recherche (E30) dans le modèle de développement (36) de l'élément de modélisation correspondant à l'identificateur (92, 93) d'élément de modélisation.

9. Le procédé selon la revendication 7 ou 8, comprenant en outre une étape de lecture de l'identificateur (94) d'opération en fonction de ladite mise en correspondance.

10. Le procédé selon la revendication 7, 8 ou 9, comprenant en outre une étape d'exécution d'une opération correspondant à l'identificateur d'opération (94).

11. Le procédé selon la revendication 10, comprenant en outre :
- une étape d'ouverture d'un fichier (90) de documentation ; et
- une étape d'écriture, dans ce fichier, de données retournées lors de ou en suite à l'exécution de ladite opération.
